# EUROPEAN PATENT SPECIFICATION

(11) **EP 0 339 322 B1**
(45) Date of publication and mention of the grant of the patent: **13.12.1995**
(21) Application number: 89106030.3
(22) Date of filing: 06.04.1989
(51) Int. Cl.: H01L 29/06

(54) **High-voltage integrated circuit with junction isolation**
Integrierte Hochspannungsschaltung mit Isolierungsübergang
Circuit intégré haute tension avec jonction d'isolation

(30) Priority: 27.04.1988 IT 2034988
(43) Date of publication of application: 02.11.1989
(73) Proprietor: SGS-THOMSON MICROELECTRONICS s.r.l., 20041 Agrate Brianza (Milano) (IT)
(72) Inventor: Siepe, Giovanni, I-28100 Novara (IT); Zullino, Lucia, I-20123 Milan (IT)
(74) Representative: Modiano, Guido, Dr.-Ing.

(56) References cited:
- EP-A- 0 061 551
- EP-A- 0 165 644
- FR-A- 2 393 423
- US-A- 4 074 293
- IEEE TRANS. ON CONSUMER ELECTRONICS, vol. CE-27, no. 3, August 1981, pages 295-302, IEEE, New York, US; F. BERTOTTI et al.: "Video stages I.C. implementedwith new, rugged junction isolation technology"

## Description

The present invention relates to an integrated circuit for high voltage with junction isolation.

As is known, one of the greatest problems of high-voltage integrated circuits with junction isolation (i.e. in which the different wells to be electrically separated are isolated by means of regions of appropriate conductivity set at such a potential as to form reverse-biased junctions with the wells to be isolated) is caused by the presence of high-potential metallizations which extend on the surface of the circuit and overlie the isolation regions. Said metallizations, in fact, lower the breakdown voltage of the junction formed by the epitaxial layer accommodating the various wells and by the isolation regions. In particular, when the insulating oxide layer which covers the surface portion of this region is covered by a high-potential electrode, the shape of the depletion region and the distribution of the electric field in the surface region are modified, causing an early breakdown of the isolation/epitaxial layer junction.

In order to solve this problem an increase in the thickness of the silicon oxide insulation layer, interposed between the isolation regions and the metallizations, has been proposed. This solution however has some intrinsic limitations due to current technological possibilities and entails considerable difficulties in integration with signal components for which low oxide thicknesses are required. In order to overcome these limitations, field plates, that is electrostatic shields of polycrystalline silicon, connected to the ground and embedded in the silicon oxide, have been used hitherto; by covering the junctions, said shields alter the depletion regions and the electric field proximate to the surface and provide higher breakdown voltage values.

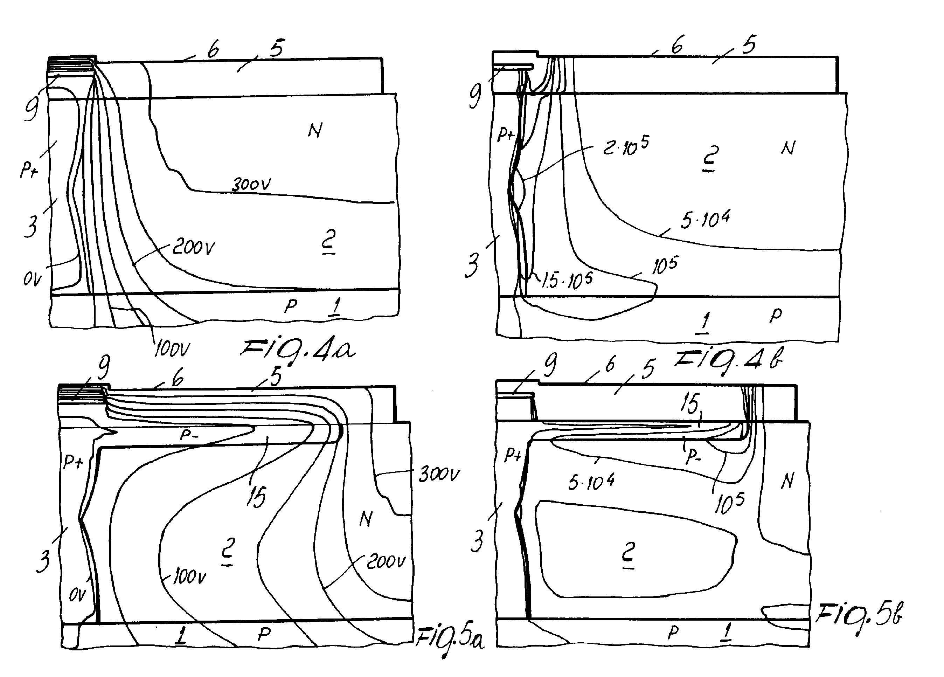

However, there is a limit value for the linear dimensions of these field plates above which their performance declines. For a better understanding of this behavior, reference should be made to figures 4a and 4b, which respectively illustrate the distribution of the equipotential lines and of the electric-field lines with constant modulus. As can be seen, the clustering of the potential lines proximate to the end of the field plate (layer 9) induces considerable electric fields at the surface, causing breakdown at approximately 300 V.

Document FR-A-2,393,423 discloses a possible embodiment of such field plates.

Furthermore, in order to increase the breakdown voltage of reverse biased pn junctions, document EP-A-0,165,644 discloses a device having floating zones located besides the pn junction within the range of the depletion zone, which also form planar pn junctions with the substrate.

Given this situation, the aim of the present invention is to provide an integrated circuit for high voltage with junction isolation, capable of solving the problems of the prior art and in particular of withstanding higher voltages with no risk of junction breakdown.

Within this aim, a particular object of the present invention is to provide an integrated circuit with junction isolation which entails no modifications, and does not negatively affect, other parts of the circuit and in particular does not entail increases in the thickness of the insulating oxide which covers the surface of the circuit.

Not least object of the present invention is to provide an integrated circuit which is structurally simple and can be produced using individual steps which are per se well-known in the electronics industry, in order to have a manufacturing cost comparable with that of known solutions.

This aim, the objects mentioned and others which will become apparent hereinafter are achieved by the integrated circuit for high voltage with junction isolation and the process for manufacturing the same, as defined in the accompanying claims.

The characteristics and advantages of the present invention will become apparent from the description of a preferred but not exclusive embodiment, illustrated merely by way of non-limitative example in the accompanying drawings, wherein:
figure 1 is a transverse sectional view across a wafer of semiconductor material accommodating an integrated circuit with junction isolation covered by a high-potential metallization;
figure 2 is a similar sectional view of an electric circuit having a known electrostatic shield;
figure 3 is a similar sectional view of the integrated circuit according to the invention;
figures 4a and 4b are plots of the distribution of the equipotential lines and of the electric field lines for the known circuit of figure 2; and
figures 5a and 5b are plots of the distribution of the equipotential lines and of the electric field lines (at an equal voltage) for the circuit according to the invention.

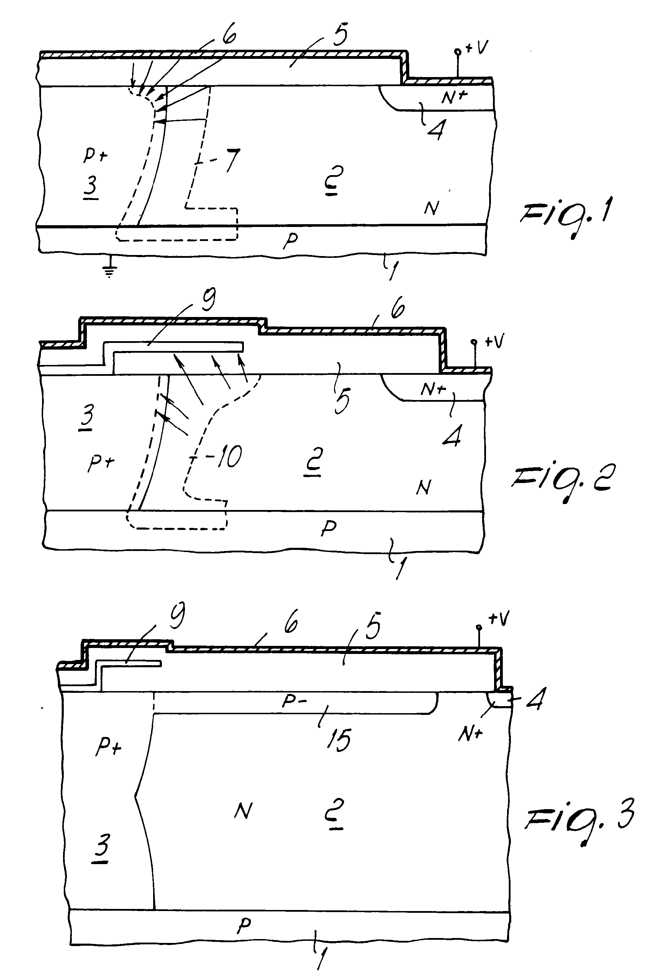

Reference is made to figure 1, which illustrates a portion of an integrated circuit comprising a junction isolation. In this figure, as in the following ones in which similar parts have been indicated by the same reference numerals, 1 indicates the substrate with P-type conductivity covered by an N-type epitaxial layer. The P⁺-type region 3 is used for the junction isolation of the epitaxial well or region 2, illustrated in the figure, from the adjacent epitaxial regions, which are not illustrated. The well 2 accommodates a layer 4 with N⁺-type conductivity which belongs to a component of the integrated circuit. On the surface of the semiconductor material body 1-4 there is a silicon oxide layer 5, and a metallization 6 (which makes contact with the region 4) extends on said layer 5 and passes above the isolation region 3. Said metallization 6, which is set to a high potential (symbolized in the figure by the contact connected to the voltage +V) alters the shape of the depletion region which forms around the junction between the epitaxial layer 2 and the isolation region 3. Said depletion region 7 has been illustrated in the figure in broken lines.

Figure 2 instead illustrates a known circuit in which the electrostatic shield (field plate) allowing to increase the breakdown voltage is provided. As can be seen, in this case a polycrystalline silicon region 9 has been provided inside the oxide layer 5. Said region 9 forming a field plate, is connected to the ground and has a portion in contact with the isolation region 3 and a region which overlies the junction and is completely embedded in the oxide 5. The reference numeral 10 indicates the depletion region around the junction, which as can be seen is altered with respect to the case illustrated in figure 1. The region 9 in practice "shields" the effect of the metallization 6, thus increasing the breakdown voltage.

An example of the distribution of the equipotential lines and of the electric field lines with constant modulus for the known solution of figure 2 is illustrated in figures 4a and 4b, from which, as mentioned, it can be seen that the clustering or crowding of the potential lines proximate to the end portion of the shield 9, with a total oxide thickness of approximately 4 »m, induces considerable fields on the surface, causing the breakdown of the junction at a voltage of approximately 300 V (the value of the electric field lines in figure 4b is given in V/cm).

Figure 3 instead illustrates an example of the solution according to the invention. As can be seen, according to the invention, besides the polycrystalline silicon shield 9 above the junction, a P⁻-type region 15 has been provided which extends along the surface of the body of semiconductor material and more precisely inside the epitaxial well 2 from the isolation region 3 towards the interior of said epitaxial well 2 below the metallization 6. Said region 15, together with the shield 9, extends the region on which the potential drop is distributed, thus preventing early breakdown.

This fact is pointed out by figures 5a and 5b which respectively illustrate the distribution of the equipotential lines and of the electric field lines with constant modulus for the solution according to the invention. As can be seen, the high-resistivity diffusion 15 allows a more uniform distribution of the potential lines with respect to the similar distributions shown in figures 4a and 4b, and therefore the electric field at the end portion of the polycrystalline-silicon shield 9 decreases considerably. The breakdown voltage is therefore raised by a few hundred volts, by virtue of this solution, by appropriately dimensioning the region 9.

The production of the isolation according to the invention does not require complicated process steps. For example, starting from a P-type substrate, boron is implanted in a known manner to form the lower part of the isolation region 3 (bottom isolation). This is followed by the N-type epitaxial growth (with phosphorus doping), forming the layer 2. A further boron implanting is then performed to provide the upper portion of the isolation (top isolation), followed by a masking to form the extension region 15. The P⁻ implanting of boron (for example with a dose of 3-6x10¹²cm⁻², an implanting energy of 70 keV for a length of 50-150 »m) then follows. A thermal step is then executed to diffuse the isolation, and then all the other regions of the device, including the silicon oxide layer, the electrostatic shield (field plate) and the metallizations, are produced in a known manner according to the circuit to be obtained.

As can be seen from the above description, the invention fully achieves the intended aim and objects. In fact, by virtue of the described solution, the isolation junction can withstand higher voltages, and in particular the surface metallizations passing above the isolation junction can have higher voltages with respect to the case in which only the polycrystalline-silicon electrostatic shield (field plate) is present.

The described solution is furthermore extremely simple and reliable and requires no complicated process steps, so that the cost of the finished integrated circuit is comparable with that of known devices.

The invention thus conceived is susceptible to numerous modifications and variations, all of which are within the scope of the inventive concept. In particular the fact is stressed that though reference has been made in the example to a structure formed by an N-type epitaxial layer and by a P-type isolation, the described solution is obviously also applicable to circuits having an epitaxial layer and junction isolation of the opposite conductivity type.

All the details may furthermore be replaced with other technically equivalent ones.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. A high voltage integrated circuit with junction isolation, comprising
at least one epitaxial region (2) of a first conductivity type and at least one isolation region (3) extending to an upper surface of said epitaxial region,
said isolation region being of a second conductivity type opposite to the first and forming a junction with said epitaxial region (2),
said junction being reverse-biased in use, an electrically insulating layer (5) formed on the upper surface of said epitaxial region and of said isolation region,
at least one further region (15) of said second conductivity type extending from said isolation region (3) into said epitaxial region (2) along the upper surface of said epitaxial region,
said further region having a lower level of doping impurities than said isolation region,
at least one field plate (9) of polycrystalline silicon overlying and being electrically connected to said isolation region through said insulating layer (5),
an electrically conducting layer (6) extending above said insulating layer (5) partially over said junction and being held at a high potential in use,
said further region (15) extending below said electrically conducting layer (6) and extending farther along the upper surface of said epitaxial region than said field plate (9).

2. An integrated circuit according to claim 1, characterized in that said further region (15) extends parallel to said insulating layer (5) in direct contact therewith.

3. An integrated circuit according to claim 1 or 2, characterized in that said further region (15) extends below part of said electrically conducting shaped layer (6).

4. An integrated circuit according to one or more of the preceding claims, characterized in that said first conductivity type is the N type and said second conductivity type is the P type.

5. An integrated circuit according to any of the preceding claims, characterized in that the level of doping impurities of said further region (15) is comprised between 1 and 9x10¹²cm⁻².

6. A process for manufacturing a high voltage integrated circuit in a semiconductor body (2) of a first conductivity type having isolation regions (3) of a second conductivity type opposite to the first,
said isolation regions forming isolation junctions with said semiconductor body extending to an upper surface to said semiconductor body,
the process comprising the steps of:
selectively doping said semiconductor body by impurities of the second conductivity type to form further regions (15) along said upper surface of said semiconductor body extending from said isolation regions (3) and having a lower concentration doping impurities than said isolation regions,
said doping step being followed by at least the steps of growing an insulating layer (5) on said semiconductor body and forming field plates (9) of polycristalline material on said insulating layer (5) and above said isolation regions (3),
said further regions (15) extending farther along the upper surface of said semiconductor body than said field plates (9).

## Patentansprüche

1. Integrierte Schaltung für hohe Spannungen mit isoliertem Übergang, mit
wenigstens einer Epitaxieregion (2) eines ersten Leitfähigkeitstyps und wenigstens einer Isolationsregion (3), welche sich bis zu einer oberen Oberfläche der Epitaxieregion erstreckt,
wobei die Isolationsregion aus einem zweiten Leitfähigkeitstyp besteht, der dem ersten entgegengesetzt ist und einen Übergang mit der Epitaxieregion (2) bildet, wobei der Übergang im Betrieb in Sperrrichtung vorgespannt ist,
einer elektrisch isolierenden Schicht (5), die auf der oberen Oberfläche der Epitaxieregion und der Isolationsregion ausgebildet ist,
wenigstens einer weiteren Region (15) des zweiten Leitfähigkeitstyps, welche sich von der Isolationsregion (3) in die Epitaxieregion (2) entlang der oberen Oberfläche der Epitaxieregion erstreckt,
wobei die weitere Region eine geringere Dotierkonzentration als die Isolationsregion aufweist,
wenigstens einer Feldplatte (9) aus polykristallinem Silizium, welche durch die Isolationsschicht (5) hindurch mit der Isolationsregion elektrisch verbunden ist und diese überlappt,
einer elektrisch leitenden Schicht (6), welche sich oberhalb der isolierenden Schicht (5) teilweise oberhalb des Überganges erstreckt und während des Betriebes auf einen hohen Potential gehalten wird,
wobei die weitere Region (15) sich unterhalb der elektrisch leitenden Schicht (6) erstreckt und sich weiter entlang der oberen Oberfläche der Epitaxieregion erstreckt als die Feldplatte (9).

2. Integrierte Schaltung nach Anspruch 1,
dadurch gekennzeichnet, daß die weitere Region (15) sich parallel zu der isolierenden Schicht (5) in direktem Kontakt damit erstreckt.

3. Integrierte Schaltung nach Anspruch 1 oder 2,
dadurch gekennzeichnet, daß die weitere Region (15) sich unterhalb eines Teils der elektrisch leitend ausgeformten Schicht (6) erstreckt.

4. Integrierte Schaltung nach einem oder mehreren der vorstehenden Ansprüche,
dadurch gekennzeichnet, daß der erste Leitfähigkeitstyp der N-Typ ist und der zweite Leitfähigkeitstyp der P-Typ ist.

5. Integrierte Schaltung nach einem der vorstehenden Ansprüche,
dadurch gekennzeichnet, daß die Dotierkonzentration der weiteren Region (15) zwischen 1 und 9·10¹²cm⁻² beträgt.

6. Verfahren zum Herstellen einer integrierten Schaltung für hohe Spannungen in einem Halbleiterkörper (2) eines ersten Leitfähigkeitstyps mit Isolationsregionen (3) eines zweiten entgegengesetzten Leitfähigkeitstyps,
wobei die Isolationsregionen isolierte Übergänge mit dem Halbleiterkörper bilden, die sich zu einer oberen Oberfläche des Halbleiterkörpers hin erstrecken,
wobei das Verfahren die Schritte umfaßt:
selektives Dotieren des Halbleiterkörpers durch Verunreinigungen des zweiten Leitfähigkeitstyps zum Bilden weiterer Regionen (15) entlang der oberen Oberfläche des Halbleiterkörpers, welche sich von den Isolationsregionen (3) erstrecken und eine geringere Dotierkonzentration als die Isolationsregionen aufweisen,
wobei der Dotierungsschritt gefolgt wird von wenigstens den Schritten des Aufwachsens einer Isolationsschicht (5) auf dem Halbleiterkörper und Ausbilden der Feldplatten (9) aus polykristallinem Material auf der Isolationsschicht (5) und oberhalb der Isolationsregionen (3),
wobei die weiteren Regionen (15) sich weiter entlang der oberen Oberfläche des Halbleiterkörpers erstrecken als die Feldplatten (9).

## Revendications

1. Circuit intégré haute tension à isolement par jonction, comprenant :
au moins une région épitaxiale (2) d'un premier type de conductivité et au moins une région d'isolement (3) s'étendant jusqu'à la surface supérieure de la région épitaxiale,
la région d'isolement étant d'un deuxième type de conductivité opposé au premier et formant une jonction avec la région épitaxiale (2), la jonction étant polarisée en inverse en cours d'utilisation,
une couche électriquement isolante (5) formée sur la surface supérieure de la région épitaxiale et de la région d'isolement,
au moins une autre région (15) du second type de conductivité s'étendant à partir de la région d'isolement (3) dans la région épitaxiale (2) le long de la surface supérieure de la région épitaxiale,
cette autre région ayant un niveau de dopage en impuretés inférieur à celui de la région d'isolement,
au moins une plaque de champ (9) en silicium polycristallin recouvrant et étant électriquement connectée à la région d'isolement à travers la couche d'isolement (5),
une couche électriquement conductrice (6) s'étendant au-dessus de la couche isolante (5), partiellement au-dessus de la jonction et étant maintenue en utilisation à un potentiel élevé,
ladite autre région (15) s'étendant sous la couche électriquement conductrice (6) et s'étendant le long de la surface supérieure de la région épitaxiale plus loin que la plaque de champ (9).

2. Circuit intégré selon la revendication 1, caractérisé en ce que ladite autre région (15) s'étend parallèlement à la couche isolante (5) en contact direct avec celle-ci.

3. Circuit intégré selon la revendication 1 ou 2, caractérisé en ce que ladite autre région (15) s'étend en dessous d'une partie de la couche électriquement conductrice (6).

4. Circuit intégré selon l'une quelconque des revendications précédentes, caractérisé en ce que le premier type de conductivité est le type N et le second type de conductivité est le type P.

5. Circuit intégré selon l'une quelconque des revendications précédentes, caractérisé en ce que le niveau de dopage en impuretés de ladite autre région (15) est compris entre 1 et 9x1012 cm-2.

6. Procédé de fabrication d'un circuit intégré haute tension dans un corps semiconducteur (2) d'un premier type de conductivité comportant des régions d'isolement (3) d'un second type de conductivité opposé au premier,
les régions d'isolement formant des jonctions d'isolement avec le corps semiconducteur, s'étendant vers une surface supérieure du corps semiconducteur,
le procédé comprenant les étapes suivantes :
doper sélectivement le corps semiconducteur en impuretés du second type de conductivité pour former d'autres régions (15) le long de la surface supérieure du corps semiconducteur s'étendant à partir des régions d'isolement (3) et ayant une concentration plus faible en impuretés dopantes que les régions d'isolement,
l'étape de dopage étant suivie d'au moins les étapes consistant à faire croître une couche isolante (5) sur le corps semiconducteur et à former des plaques de champ (9) de matériau polycristallin sur la couche isolante (5) et au-dessus des régions d'isolement (3),
lesdites autres régions (15) s'étendant plus loin le long de la surface supérieure du corps semiconducteur que les plaques de champ (9).
